# EUROPÄISCHE PATENTSCHRIFT

(11) **EP 1 122 608 B1**
(45) Veröffentlichungstag und Bekanntmachung des Hinweises auf die Patenterteilung: **29.08.2007**
(21) Anmeldenummer: 01100542.8
(22) Anmeldetag: 10.01.2001
(51) Int. Cl.: G03F 7/20

(54) **Projektionsbelichtungsanlage mit reflektivem Retikel**
Projection exposure system with reflective reticle
Système d'exposition par projection avec réticule réflectif

(30) Priorität: 05.02.2000 DE 10005189
(43) Veröffentlichungstag der Anmeldung: 08.08.2001
(73) Patentinhaber: Carl Zeiss SMT AG, 73447 Oberkochen (DE)
(72) Erfinder: Fürter, Gerd, 73479 Ellwangen (DE); Wagner, Christian, Dr., 73431 Aalen (DE); Gödecke, Uwe, 73453 Abtsgmünd (DE); Müller, Henriette, 73434 Aalen (DE)
(74) Vertreter: Schultz, Jörg Martin

(56) Entgegenhaltungen:
- WO-A-93/09469
- PATENT ABSTRACTS OF JAPAN Bd. 018, Nr. 387 (P-1773), 20. Juli 1994 (1994-07-20) -& JP 06 110213 A (DAINIPPON SCREEN MFG CO LTD), 22. April 1994 (1994-04-22)
- PATENT ABSTRACTS OF JAPAN Bd. 018, Nr. 573 (E-1624), 2. November 1994 (1994-11-02) -& JP 06 215997 A (NIKON CORP), 5. August 1994 (1994-08-05)
- PATENT ABSTRACTS OF JAPAN Bd. 010, Nr. 215 (P-481), 26. Juli 1986 (1986-07-26) -& JP 61 053646 A (NIPPON KOGAKU KK <NIKON>), 17. März 1986 (1986-03-17)

## Beschreibung

Die Erfindung betrifft eine Projektionsbelichtungsanlage mit einem Retikel, das in Reflektion betrieben wird.

Projektionsbelichtungsanlagen mit reflektivem Retikel wurden in der Vergangenheit unter anderem zusammen mit 1:1 Dyson-Objektiven eingesetzt, wie sie in folgenden Schriften beschrieben werden.
- Owen, G. et al. "1/8 µm optical lithography" J. Vac. Sci. B 10 (1992), p. 3032-3036 - besonders Teile B und C
- Owen, G. et al. "Lithography for 0,25 µm und below ..." IEEE 1992 Symp. VLSI Technology (02.06.92) p. 116-117
- Jeong, H. et al. "Optical projection system ..." J. Vac. Sci. B 11 (1993) p. 2675-2679
- US 4,964,705 Markle.

Die Einkopplung der Beleuchtung erfolgt dabei über einen teildurchlässigen Spiegel, wie er z.B. in US 4,964,705 Fig. 3 gezeigt wird. Strahlteilerwürfel oder Strahlteilerplatten sind in diesen Designs nicht vorgesehen.

Bei der Lithographie mit weichen Röntgenstrahlen (EUVL) wird ausschließlich mit reflektiven Retikeln gearbeitet. Die Strahlteilung von Beleuchtungs- und abbildendem Strahlengang wird durch schiefen Einfall der Beleuchtung realisiert. Strahlteilerwürfel oder Strahlteilerplatten kommen nicht zum Einsatz. Die Objektive sind reine Spiegelobjektive mit nicht axialsymmetrischem Strahlengang. Der schräge Einfall des Beleuchtungslichtes auf das reflektive Retikel hat den Nachteil, daß die erhöhten Maskenstege zu Vignettierung führen.

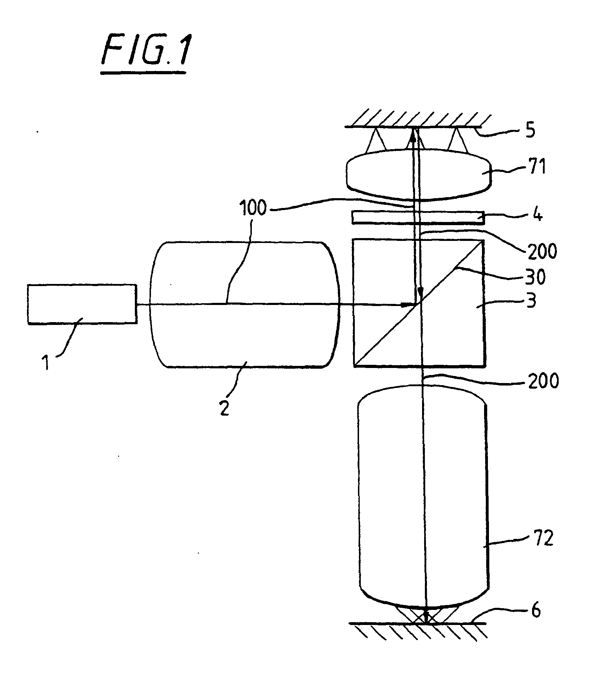

Weiter ist aus JP-A 9-017719 eine Wafer-Projektionsbelichtungsanlage mit Reflex-LCD als besonderem Retikel bekannt. Ausweislich deren Figur 1 wird eine plane Strahlteilerplatte zur Trennung von Beleuchtungs- und Abbildungsstrahlengang eingesetzt. Beleuchtungssystem und Projektionsobjektiv werden mit einem zur optischen Achse symmetrischen Feld betrieben. Die Einkopplung des Beleuchtungslichts mittels einer Strahlteilerplatte direkt vor dem Retikel entsprechend JP-A 9-017719 erfordert zum einen die entsprechende Eingangsschnittweite, zum anderen führt der Durchtritt durch die Planplatte zur astigmatischen Deformation des Beleuchtungslichtbündels, welche die erforderliche saubere Pupillenabbildung stört.

Aus der JP 6 110213 A und der JP 6 1053646 A sind refraktive Projektionsobjektive mit integriertem Strahlteilerwürfel und einem reflektivem Retikel als abzubildendem Objekt bekannt. Diese Projektionsobjektive weisen jedoch kein Zwischenbild auf. Aus der JP 6 215997 A ist ein Projektionsobjektiv mit einem Strahlteilerwürfel bekannt, der den Beleuchtungs- und den Abbildungsstrahlengang überlagert. Das abzubildende Objekt ist dabei ein transmittierendes Retikel.

Aus der US 5,956,174 ist ein katadioptrisches Mikroskopobjektiv bekannt, bei dem über einen Strahlteilerwürfel zwischen Mikroskopobjektiv und Tubuslinse das Beleuchtungslicht eingekoppelt wird. Diese Art der Beleuchtung ist bei Auflichtmikroskopen durchaus üblich. Die ausgeleuchteten Feldgrößen liegen dabei nur in der Größenordnung von 0,5mm.

Katadioptrische Systeme für die Wellenlängen 193 nm und 157 nm sind bekannt. So geben die Offenlegungsschriften DE 44 17 489 A1 (US ser. no. 08/583 025) und DE 196 16 922 A1 (US ser. no. 08/845 384) der Anmelderin katadioptrische Projektionsobjektive mit Strahlteilerwürfel ohne Zwischenbild an.

Katadioptrische Projektionsobjektive mit Strahlteilerwürfel und Zwischenbild sind der anhängigen Anmeldung DE 199 54 727.0 mit dem Titel "Katadioptrisches Objektiv mit physikalischen Strahlteilern und Zwischenbild" zu entnehmen.

Beleuchtungseinrichtungen für die Mikrolithographie werden in den Offenlegungsschriften DE 44 21 053 A1 (US ser. no. 08/490 752) und DE 195 20 563 A1 (US ser. no. 08/658 605) vorgestellt. Sogenannte REMA-Objektive zur Abbildung einer Retikel-Maskiereinrichtung (REMA) in die Ebene des Retikels sind aus den Offenlegungsschriften DE 195 48 805 A1 (US ser. no. 08/771 654) und DE 196 53 983 A1 (US ser. no. 09/125 621) bekannt. Mit diesen Objektiven wird unter anderem die Eintrittspupille des nachfolgenden Projektionsobjektives beleuchtet.

Die Herstellung von Transmissions-Retikels, also in Transmission betriebene Masken für die Mikrolithographie, ist für tiefe UV-Wellenlängen, insbesondere 157 nm, u.a. wegen des geeigneten transmittierenden Trägermaterials schwierig. Denkbar sind die Materialien CaF₂ oder MgF₂. Retikels aus CaF₂ oder MgF₂ sind jedoch schlecht zu bearbeiten und dadurch sehr teuer. Zudem kommt es durch Absorption und durch die daraus resultierende thermische Ausdehnung des Retikels bei Mehrfachbelichtungen zu einer Reduzierung der minimalen Strukturgröße, die auf einem Halbleiterchip aufgebracht werden kann. Wenn möglich wird auf Materialien wie MgF₂ verzichtet, da sie zudem doppelbrechend sind.

Die Alternative sind reflektive Retikels. Zur Entspannung der Anforderungen an das Retikel ist es vorteilhaft, wenn das Projektionsobjektiv als Reduktionsobjektiv ausgebildet ist und das Retikel verkleinert abbildet. Dann kann das Retikel mit größeren Strukturen versehen werden.

Bei herkömmlichen Reduktionsobjektiven ist der Einsatz von reflektiven Retikels nicht ohne weiteres möglich. Die typische Eingangsschnittweite von z.B. 30 mm verhindert die Beleuchtung unter geeigneten Inzidenzwinkeln.

Aufgabe der Erfindung ist es daher, Projektionsbelichtungsanlagen mit Reduktionsobjektiv anzugeben, die mit reflektivem Retikel einwandfreie Funktion ergeben.

Gelöst wird diese Aufgabe durch eine Projektionsbelichtungsanlage der Mikrolithographie nach Anspruch 1, bei der ein Strahlteilerwürfel zur Überlagerung von Beleuchtungs- und Abbildungsstrahlengang dient. Damit lassen sich zahlreiche Objektiv-Designkonzepte für reflektive Retikels adaptieren, wie die folgenden Beispiele zeigen. Durch Verwendung eines Strahlteilerwürfels an Stelle einer planparallelen Strahlteilerplatte werden Fehlereinträge der im Durchtritt betriebenen, unter 45° angebrachten Strahlteilerplatte vermieden. Um den Strahlteilerwürfel in das Design des Reduktionsobjektives leichter integrieren zu können, ist das Reduktionsobjektiv in zwei Teilobjektive aufgeteilt, vorteilhaft, mit einer ersten Zwischenabbildung mit einem Abbildungsmaßstab von -1,0 ± 0,25 und einer zweiten Abbildung mit einen Abbildungsmaßstab von -0,25 ± 0,15. Der Strahlteilerwürfel wird dabei in die erste Zwischenabbildung integriert. Die zweite Abbildung kann rein refraktiv oder katadioptrisch ausgebildet sein.

Nach Anspruch 2 ist es vorteilhaft, zwischen Strahlteilerwürfel und Retikel optische Elemente vorzusehen. Mit diesen optischen Elementen ist es möglich, die Inzidenzwinkel der Hauptstrahlen des Reduktionsobjektives auf dem Retikel derart zu reduzieren, daß sie Werte zwischen ±15mrad aufweisen.

Das Beleuchtungssystem soll nach Anspruch 4 so ausgelegt sein, daß der Beleuchtungsstrahlengang mit Abweichungen kleiner als ± 2,5mrad in den abbildenden Strahlengang übergeht. Meßbar ist diese Abweichung, indem man für die Schwerstrahlen nach der Reflektion am Retikel die Winkel bezüglich der Retikelebene bestimmt und die Abweichung zu den Winkeln der korrespondierenden Hauptstrahlen berechnet. Die Winkel der Schwerstrahlen sind von der Abstrahlcharakteristik der Lichtquelle und dem Design des Beleuchtungssystems, die Winkel der Hauptstrahlen ausschließlich vom Design des Reduktionsobjektives abhängig.

Um Transmissionsverluste am Strahlteilerwürfel zu reduzieren und kein Streulicht auf den Wafer zu lenken, wird nach Anspruch 5 ein Polarisations-Strahlteilerwürfel verwendet. Für eine optimale Funktionsweise muß das Beleuchtungslicht zu mehr als 95% linear polarisiert sein. Die Polarisationsrichtung hängt davon ab, ob der Beleuchtungsstrahlengang an der Strahlteilerschicht reflektiert werden soll oder nicht. Im Falle einer Reflektion muß das Beleuchtungslicht parallel zur Strahlteilerfläche polarisiert sein, im Falle der Transmissions senkrecht zur Strahlteilerfläche.

Die Ansprüche 6-9 betreffen Ausführungsformen, bei denen der Strahlteilerwürfel ausschließlich zur Einkopplung des Beleuchtungsstrahlengangs dient.

Besonders vorteilhaft ist die Einkopplung des Beleuchtungsstrahlengangs mit einem Strahlteilerwürfel, wenn der Strahlteilerwürfel gemäß den Ansprüchen 10-12 bereits Bestandteil des Reduktionsobjektives ist. Dann kann die vierte ungenutzte Seite des Strahlteilerwürfels zur Einkopplung des Beleuchtungsstrahlengangs genutzt werden.

Weist das Design eines katadioptrischen Objektives einen Umlenkspiegel auf, so kann der Umlenkspiegel durch einen Strahlteilerwürfel ersetzt werden, über den das Beleuchtungslicht eingekoppelt wird.

Anspruch 14 gibt ein Herstellverfahren für mikrolithographische Bauteile an, das durch die Verwendung einer Projektionsbelichtungsanlage nach einem der vorhergehenden Ansprüchen gekennzeichnet ist.

Die erfindungsgemäße Überlagerung von Beleuchtungs- und Projektionsoptik ermöglicht insbesondere bei Betriebswellenlängen im Bereich von 100-200nm den Einsatz von reflektiven Retikeln. Dadurch umgeht man die Schwierigkeiten, die bei der Herstellung von Transmissions-Retikels durch die Bearbeitung der bei diesen Wellenlängen transparenten Materialien auftreten.

Näher erläutert wird die Erfindung anhand der Zeichnungen.
Fig. 1 zeigt ein Reduktionsobjektiv mit einem reflektiven Retikel und einem Strahlteilerwürfel zur Einkopplung des Beleuchtungslichts.
Fig. 2 zeigt ein Reduktionsobjektiv mit vorgeschaltener Zwischenabbildung, in die der Strahlteilerwürfel zur Beleuchtungseinkopplung integriert ist.
Fig. 3 zeigt ein kadadioptrisches Reduktionsobjektiv mit vorgeschaltener Zwischenabbildung, in die der Strahlteilerwürfel zur Beleuchtungseinkopplung integriert ist.
Fig. 4 zeigt ein kadadioptrisches Reduktionsobjektiv ohne Zwischenabbildung , wobei der Beleuchtungsstrahlengang über den Strahlteilerwürfel des katadioptrischen Reduktionsobjektivs eingekoppelt wird.
Fig. 5 zeigt ein kadadioptrisches Reduktionsobjektiv ohne Zwischenabbildung, wobei die Beleuchtung über einen Strahlteilerwürfel am Ort der Umlenkung eingekoppelt wird.
Fig. 6 zeigt ein kadadioptrisches Reduktionsobjektiv mit Zwischenabbildung , wobei die Beleuchtung über den Strahlteilerwürfel des katadioptrischen Reduktionsobjektivs eingekoppelt wird.
Fig. 7 zeigt ein Ausführungsbeispiel für ein katadioptrisches Reduktionsobjektiv mit Strahlteilerwürfel und Zwischenabbildung.

In Fig. 1 ist der typische Aufbau einer beispielhaften Projektionsbelichtungsanlage für die Mikrolithographie dargestellt. Das reflektive Retikel 5 wird über eine verkleinernde Abbildung mit einem typischen Abbildungsmaßstab β von -0,25 ± 0,15 auf den Wafer 6 abgebildet. Das ausgeleuchtete Feld auf dem Wafer 6 weist dabei einen Durchmesser von mindestens 10mm auf. Typisch sind rechteckige Felder mit einem x-y-Aspektverhältnis von 1:1 bis 1:4. Die bildseitige numerische Apertur ist größer als 0,5. Die Abbildung erfolgt über die optischen Elemente 71 und 72. Zur Beleuchtung des reflektiven Retikels 5 wird in den Abbildungsstrahlengang 200 des Reduktionsobjektives zwischen reflektivem Retikel 5 und Wafer 6 ein Strahlteilerwürfel 3 integriert. Dabei kann es sich z.B. um einen Polarisations-Strahlteilerwürfel 3 handeln, bei dem sich zwischen den Prismenflächen ein Schichtsystem befindet, das parallel zur Strahlteilerfläche 30 polarisiertes Licht nahezu vollständig reflektiert, für senkrecht zur Strahlteilerfläche 30 polarisiertes Licht jedoch durchlässig ist. Voraussetzung für die Anordnung nach Fig. 1 ist es deshalb, daß das Beleuchtungslicht parallel zur Einfallsebene der unter 45° angebrachten Strahlteilerfläche 30 polarisiert ist. Derart polarisiertes Licht wird an der Strahlteilerfläche 30 reflektiert und in Richtung reflektives Retikel 5 abgelenkt. Zwischen Strahlteilerwürfel 3 und reflektivem Retikel 5 ist ein λ/4-Plättchen 4 angebracht, das insgesamt zweimal durchlaufen wird. Ein erstes Mal im Beleuchtungsstrahlengang 100, so daß das linear polarisierte Licht zirkular polarisiert wird.

Nach der Reflektion am Retikel 5 läuft das zirkular polarisierte Licht im abbildenden Strahlengang 200 ein zweites Mal durch das λ/4-Plättchen 4 und ist nunmehr wieder linear polarisiert. Die Polarisationsrichtung ist nun jedoch senkrecht zur Strahlteilerfläche 30 des Strahlteilerwürfels 3 ausgerichtet, so daß der Strahlteilerwürfel 3 ohne Reflektion durchlaufen wird. Damit ist eine Trennung des Beleuchtungsstrahlengangs 100 und des abbildenden Strahlengangs 200 in der Kombination von Polarisations-Strahlteilerwürfel 3, zweimaligem Durchlauf des λ/4-Plättchens 4 und reflektivem Retikel 5 gegeben. Eine planparallele Strahlteilerplatte hätte gegenüber dem Polarisations-Strahlteilerwürfel 3 den Nachteil, daß durch die unter 45° gestellte Strahlteilerplatte endlicher Dicke nicht rotationssymmetrische Abbildungsfehler eingeführt würden.

Der Polarisations-Strahlteilerwürfel 3 sollte innerhalb des abbildenden Strahlengangs 200 an einer Stelle angeordnet werden, an der die auf die Strahlteilerfläche 30 treffenden Strahlen eine geringe Divergenz aufweisen. Das ist dann der Fall, wenn der Polarisatoins-Strahlteilerwürfel 3 sich an einem Ort mit nahezu kollimiertem Strahlengang befindet.
Zwischen reflektivem Retikel 5 und Polarisations-Strahlteilerwürfel 3 sind deshalb optische Elemente 71 mit insgesamt positiver Brechkraft vorzusehen, die das vom Retikel kommende divergierende Lichtbündel im wesentlichen kollimieren. Die optischen Elemente 72 können je nach Designtyp unterschiedlich ausgelegt sein, besitzen jedoch insgesamt ebenfalls positive Brechkraft, um die Abbildung auf eine mögliche Zwischenbildebene oder auf die Wafer-Ebene 6 zu erzielen.

Man kann sich die optischen Elemente 71 und 72 zusammengenommen als refraktives Reduktionsobjektiv mit einem typischen Abbildungsmaßstab β von -0,25±0,15 vorstellen. Im Design dieses refrakiven Objektivs ist dann zwischen den optischen Elementen 71 und den optischen Elementen 72 das λ/4-Plättchen 4 und der Strahlteilerwürfel 3 vorzusehen.

Beleuchtet wird das reflektive Retikel 5 mit Hilfe des Beleuchtungssystems 2, wobei der Strahlteilerwürfel 3, das λ/4-Plättchen 4, und die optischen Elemente 71 beim Design des Beleuchtungssystems 2 berücksichtigt werden müssen. Die Schnittstelle zwischen Beleuchtungssystem 2 und abbildender Optik ist deshalb nicht das Retikel 5, wie das bei einem Transmissions-Retikel oder bei schiefer Beleuchtung des Retikels der Fall wäre, sondern der dem Beleuchtungssystem 2 zugewandte Eingang des Strahlteilerwürfels 3.

Um den optischen Aufbau der Beleuchtungsoptik 2 zu vereinfachen, ist es günstig, wenn die Hauptstrahlwinkel bezüglich der Retikelebene kleiner als ± 15mrad sind, das Retikel 5 also nahezu telezentrisch beleuchtet wird. Die Hauptstrahlen sind im Reduktionsobjektiv so definiert, daß sie am Ort der Systemblende die optische Achse schneiden. Bei größeren Hauptstrahlwinkeln wird das Design der Beleuchtungsoptik 2 dadurch erschwert, daß die Schwerstrahlen des Beleuchtungsstrahlengangs 100 in der Retikelebene 5 in die Hauptstrahlen des abbildenden Strahlengangs 200 übergehen müssen. Aufgrund der Reflektion am Retikel müssen die Inzidenzwinkel der Schwerstrahlen das umgekehrte Vorzeichen wie die Hauptstrahlen aufweisen. Dadurch ist der Beleuchtungsstrahlengang 100 verschieden vom abbildenden Strahlengang 200 innerhalb der optischen Komponenten 71. Die Verteilung der Hauptstrahlwinkel über das beleuchtete Feld muß vom Beleuchtungssystem 2 überkompensiert werden. Da die Hauptstrahlwinkelverteilung am Retikel 5 hauptsächlich durch die optischen Elemente 71 bestimmt wird und diese optischen Elemente 71 für das Design des Beleuchtungssystems 2 fest vorgegeben sind, müssen im Beleuchtungssystem 2 optische Komponenten - beispielsweise eine Abfolge von sammelnden und zerstreuenden Linsen - vorgesehen werden, die die Schwerstrahlwinkel auf dem Retikel 5 beeinflussen.

Die optischen Komponenten im Beleuchtungssystem 2 sind so ausgelegt, daß die Schwerstrahlen des Beleuchtungsstrahlengangs 100 nach der Reflektion am reflektiven Retikel 5 je nach Feldhöhe mit den vom Design des Reduktionsobjektives vorgegebenen Hauptstrahlen bis zu einer maximalen Winkel-Abweichung von ± 2,5 mrad übereinstimmen. Andernfalls würde die üblicherweise geforderte Telezentrie in der Wafer-Ebene 6 verletzt werden.

Das Beleuchtungssystem 2 muß eine Einrichtung zur Veränderung des Polarisationszustandes des Beleuchtungslichtes enthalten. Bei linear polarisiertem Licht der Quelle 1 muß gegebenenfalls die Polarisationsrichtung z.B. über doppelbrechende Kristalle oder doppelbrechende Folien gedreht werden. Bei unpolarisiertem Licht der Quelle 1 müssen Polarisatoren zur Erzeugung von zur Strahlteilerfläche 30 parallel oder senkrecht polarisiertem Licht eingesetzt werden. Bevorzugt werden diese Komponenten zur Beeinflussung des Polarisationszustandes unmittelbar vor dem Polarisations-Strahlteilerwürfel 3 angebracht. Die Polarisationsrichtung hängt davon ab, ob der Beleuchtungsstrahlengang 100 an der Strahlteilerschicht 30 reflektiert werden soll oder nicht. Im Falle einer Reflektion z.B. muß das Beleuchtungslicht parallel zur Strahlteilerfläche 30 polarisiert sein.

Üblicherweise enthält das Beleuchtungssystem 2 zur homogenen Ausleuchtung der Retikelebene 5 Integratoren, wie z.B. Wabenkondensoren, Hohlleiter oder Glasstäbe. Zur Variation des Beleuchtungsmodus können im Beleuchtungssystem 2 Zoomoptiken, Axikon-Elemente, Filterplatten in Pupillenebenen, Maskiervorrichtungen in Pupillen- oder Zwischenfeldebenen vorgesehen sein. Die Funktionsweise dieser Elemente ist z.B. in der Offenlegungsschrift DE 195 20 563 A1 der Anmelderin beschrieben. Objektive innerhalb des Beleuchtungssystems 2 zur Anpassung der Schwerstrahlwinkel des Beleuchtungsstrahlengangs 100 an die Hauptstrahlwinkel des Reduktionsobjektives, also zur korrekten Ausleuchtung der Eintrittspupille des Reduktionsobjektives sind als REMA-Objektive aus DE 196 53 983 A oder DE 195 48 805 A1 bekannt.

Als Lichtquelle 1 kann ein DUV- oder VUV-Laser eingesetzt werden, beispielsweise ein ArF-Laser für 193nm, ein F₂-Laser für 157nm, ein Ar₂-Laser für 126nm und ein NeF-Laser für 109nm.

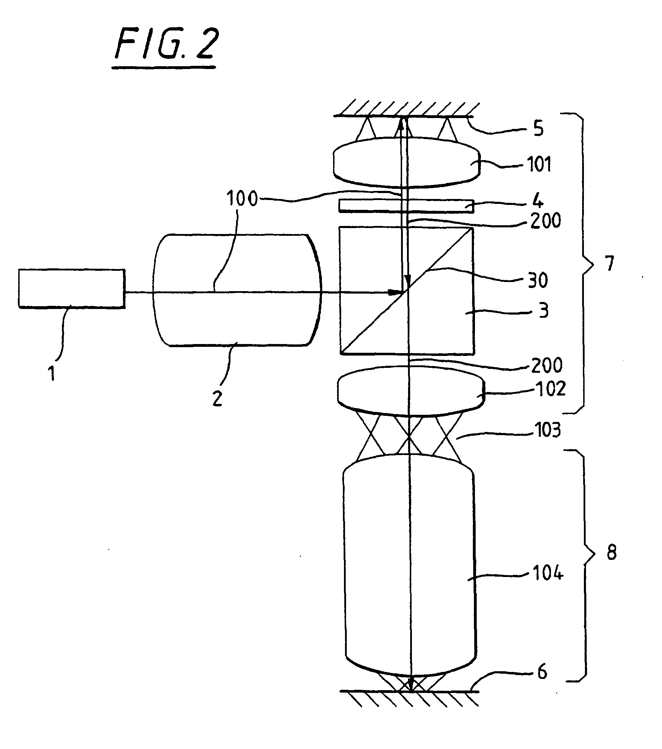

Fig. 2 zeigt eine Ausführungsform der erfinderungsgemäßen Projektionsbelichtungsanlage für die Mikrolithographie. Gleiche Teile wie in Fig. 1 wurden mit gleichen Bezugsziffern versehen. Das abbildende System 7-8 in Fig. 2 weist in diesem Fall eine Zwischenbildebene 103 auf. Das Zwischenabbildungssystem 7, bestehend aus den optischen Elementen 101, dem λ/4-Plättchen 4, dem Polarisations-Strahlteilerwürfel 3 und den optischen Elementen 102, führt dabei eine Zwischenabbildung des reflektiven Retikels 5 auf die Zwischenbildebene 103 durch. Der Abbildungsmaßstab β₁ dieser Zwischenabbildung kann β₁=-1,0±0,2 betragen. Möglich ist beispielsweise auch eine Reduktionsabbildung mit dem Abbildungsmaßstab β₁=-0,5±0,2, wenn dadurch das Design des nachfolgenden optischen Systems 8 vereinfacht wird. Die Einkopplung des Beleuchtungslichtes erfolgt in diesem Fall über den Polarisations-Strahlteilerwürfel 3 mit dem nachfolgenden λ/4- Plättchen 4 innerhalb der Zwischenabbildungsoptik 7. Die optischen Elemente 101 und 102 besitzen dabei jeweils positive Brechkraft, wobei sich der Polarisations-Strahlteilerwürfel 3 in einem Bereich mit nahezu kollimiertem Strahlengang befindet. Nach der Zwischenbildebene 103 folgen optische Elemente 104, die die Zwischenbildebene 103 auf die Wafer-Ebene 6 mit einem Abbildungsmaßstab von β₂ = -0,25 ± 0,15, bzw. β₂ = 0,5 ± 0,15 abbilden. In dieser Ausführungsform ist das Reduktionsobjektiv in das Zwischenabbildungssystem 7 und in das Reduktionssystem 8 aufgeteilt. Dies bringt den Vorteil mit sich, daß im Zwischenabbildungssystem 7 gut Raum für den Polarisations-Strahlteilerwürfel 3 geschaffen werden kann. Auch in dieser Konfiguration müssen die optischen Elemente 101, das λ/4-Plättchen 4, und das Strahlteilerwürfel 3 in das Design des Beleuchtungssystems 2 miteinbezogen werden. Es ist vorteilhaft, wenn die Zwischenabbildung 7 derart ausgelegt ist, daß das reflektive Retikel 5 nahezu telezentrisch beleuchtet wird. Die Inzidenzwinkel der Hauptstrahlen auf dem reflektiven Retikel 5 sollten dabei kleiner als 15mrad sein.

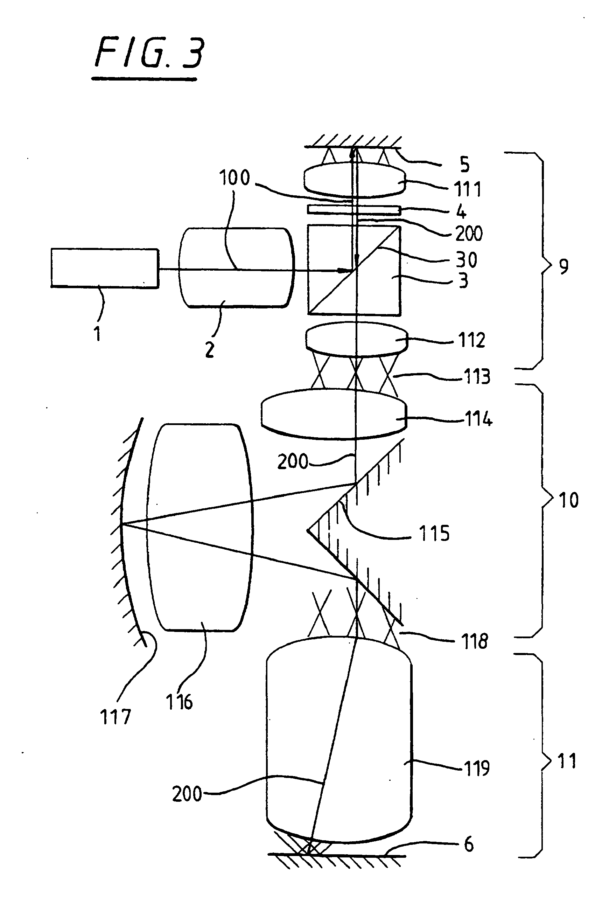

Fig. 3 zeigt eine weitere Ausführungsform der erfindungsgemäßen Projektionsbelichtungsanlage für die Mikrolithographie. Die Abbildung zwischen reflektivem Retikel 5 und Wafer-Ebene 6 erfolgt dabei mit zwei Zwischenbildebenen 113 und 118. Die Zwischenabbildung 9 von reflektivem Retikel 5 zur Zwischenbildebene 113 ist dabei ähnlich aufgebaut wie das Zwischenabbildungssystem 7 in Fig. 2. Die Abbildung von Zwischenbildebene 113 auf den Wafer 6 erfolgt zunächst mit Hilfe des katadioptrischen Zwischenabbildungssystems 10 und eines nachfolgenden refraktiven Reduktionssystems 11. Das katadioptrische Zwischenabbildungssystem 10 besteht aus den optischen Elementen 114, einem Umlenkspiegel 115, den optischen Elementen 116 und dem Konkavspiegel 117. Aufgrund des reflektiven Umlenkspiegels 115 liegt das Objektfeld des Zwischenabbildungssystem 10 nicht zentriert zur optischen Achse, sondern außerhalb der optischen Achse. Das bedeutet in diesem Fall, daß die Teilsysteme 10 und 11 versetzt zum Teilsystem 9 angeordnet werden müssen. Die bildseitige numerische Apertur kann bei diesen Projektionsobjektiven Werte im Bereich von 0,65 bis 0,8 oder mehr aufweisen. Dabei sind Feldgrößen in der Wafer-Ebene 6 im Bereich von 20mm x 7mm bis 30mm x 10mm möglich.

Derartige Objektive sind in der anhängigen Anmeldung EP 99 112 539 der Anmelderin (US ser. no. 09/364 382) beschrieben.

Besonders vorteilhaft ist die Einkopplung des Beleuchtungsstrahlengangs 100 in den abbildenden Strahlengang 200 vorzunehmen, wenn im abbildenden Strahlengang 200 bereits ein Strahlteilerwürfel vorgesehen ist, wie dies bei einigen katadioptrischen Objektivtypen der Fall ist. Katadioptrische Objektivtypen mit Strahlteilerwürfeln sind in unterschiedlichen Ausführungsformen bekannt.

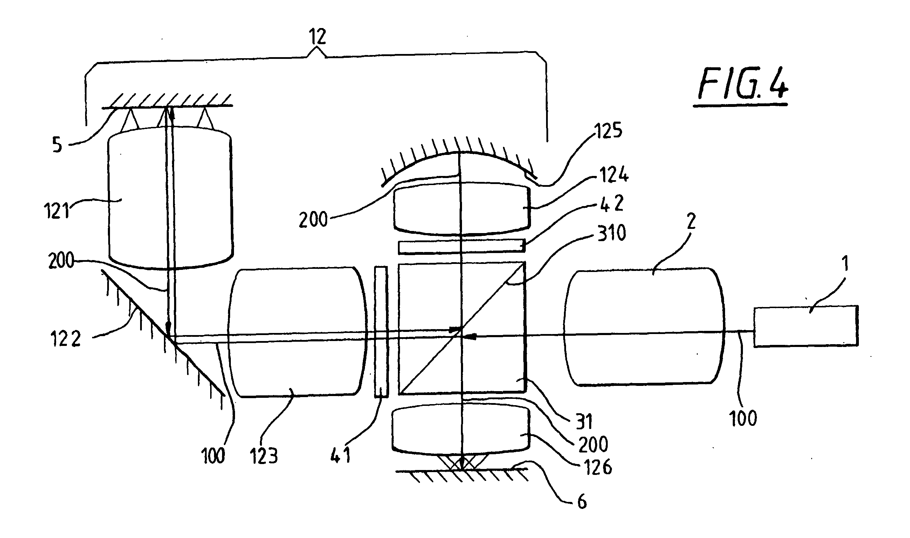

Fig. 4 zeigt ein mögliches, nicht erfindungsgemässes katadioptrisches Projektionsobjektiv mit Strahlteilerwürfel 31, das zwischenbildfrei aufgebaut ist. Derartige Objektive bestehen ausgehend vom Retikel 5 aus einer ersten Linsengruppe 121, einem Umlenkspiegel 122, einer zweiten Linsengruppe 123, dem Strahlteilerwürfel 31, einer dritten Linsengruppe 124, einem Konkavspiegel 125, einer vierten Linsengruppe 126 und einer Blende, die zwischen den Elementen 123 und 126 angeordnet ist. Denkbar ist für diese Objektive ein Abbildungsmaßstab β von -0,25 ± 0,15, eine bildseitige numerische Apertur > 0,5 und ein Bildfelddurchmesser > 10 mm, vorzugsweise > 20 mm. Die erste Linsengruppe 121 und die zweite Linsengruppe 123 können so ausgelegt werden, daß die Divergenz der Strahlen auf der Strahlteilerfläche 310 des Polarisations-Strahlteilerwürfels 31 minimiert wird. Betrachtet man einen Randstrahl, der von einem Objektpunkt auf der optischen Achse ausgeht, so kann der Sinus des Winkels dieses Strahls bezüglich der optischen Achse durch die erste und zweite Linsengruppe 121 und 123 um bis zu 40% reduziert werden. Um zusammen mit dem Konkavspiegel 125 eine ausreichende Farbkorrektur zu erzielen, muß die Linsengruppe 124 eine negative Brechkraft aufweisen. Die Linsengruppe 126 erzeugt das Bild in der Wafer-Ebene 6 und weist deshalb eine positive Brechkraft auf. Das in Fig. 4 dargestellte Reduktionsobjektiv 12 bestehend aus den optischen Elementen 121, 122, 123, 124, 125, 126 und dem Strahlteilerwürfel 31 ist der DE 196 16 922 A1 entnommen.

Verwendet man nun diesen Objektivtyp mit reflektivem Retikel 5, so kann das Beleuchtungslicht über den Polarisations-Strahlteilerwürfel 31 eingekoppelt werden. Vorteilhafterweise wird hierzu die vierte unbenutzte Seite des Polarisations-Strahlteilerwürfels 31 verwendet. Damit an der Strahlteilerfläche 310 kein Beleuchtungslicht Richtung Wafer 6 reflektiert wird und damit dadurch nicht Kontrast und Auflösung reduziert werden, ist es zwingend erforderlich, daß das Beleuchtungslicht zu mehr als 95% senkrecht zur Strahlteilerfläche 310 polarisiert ist. Deshalb ist es vorteilhaft, zwischen Beleuchtungssystem 2 und Polarisations-Strahlteilerwürfel 31 ein Polarisationsfilter einzubauen, dessen durchlässige Polarisationsrichtung senkrecht zur Strahlteilerfläche 310 orientiert ist.

Nach dem Polarisations-Strahlteilerwürfel 31 folgt ein erstes λ/4- Plättchen 41, mit dessen Hilfe die Lichtbündel des Beleuchtungsstrahlengangs 100 zirkular polarisiert werden. Die Lichtbündel des vom reflektiven Retikel 5 zum Wafer 6 verlaufenden abbildenden Strahlengangs 200 werden durch das λ/4- Plättchen 41 wiederum linear polarisiert, nun jedoch parallel zur Strahlteilerfläche 310, und werden an der Strahlteilerfläche 310 zum Konkavspiegel 125 hin reflektiert. Bevor die Lichtbündel auf den Konkavspiegel 125 fallen, werden sie durch ein zweites λ/4- Plättchen 42 zirkular polarisiert und nach der Reflektion am Konkavspiegel 125 beim zweiten Durchgang durch das zweite λ/4- Plättchen 42 wieder parallel zur Strahlteilerschicht 310 linear polarisiert, so daß sie den Polarisations-Strahlteilerwürfel 31 in Richtung Wafer 6 durchsetzen.

Bis auf das erste *λ*/4- Plättchen 41 zwischen Polarisations-Strahlteilerwürfel 31 und Retikel 5 kann ein herkömmliches katadioptrisches Reduktionsobjektiv 12 mit Polarisations-Strahlteilerwürfel 31 unverändert mit reflektivem Retikel 5 eingesetzt werden. Entscheidend ist, im Design des Beleuchtungssystems 2 die optischen Elemente des Projektionsobjektives, die vom Beleuchtungslicht ebenfalls durchlaufen werden, mitzuberücksichtigen.

Das Licht der Lichtquelle 1 wird in der Beleuchtungseinheit 2 derart konfiguriert, daß es nach Durchgang durch den Polarisations-Strahlteilerwürfel 31, das erste λ/4- Plättchen 41, die zweite Linsengruppe 123, den Umlenkspiegel 122 und die erste Linsengruppe 121, das reflektive Retikel 5 entsprechend den Lithographieanforderungen beleuchtet. Die Homogenität der Beleuchtung und der Beleuchtungsmodus, wie kohärente, inkohärente, annulare oder Quadrupol-Beleuchtung wird durch entsprechende Komponenten im Beleuchtungssystem 2 bereitgestellt. Um die Eintrittspupille des Reduktionsobjektives 12 korrekt auszuleuchten, sind der Polarisations-Strahlteilerwürfel 31 und die optischen Elemente 121 bis 123 als feste Komponenten des Beleuchtungsstrahlengangs 100 mitanzusehen und ihre Wirkung beim Design des Beleuchtungssystems 2 zu berücksichtigen.

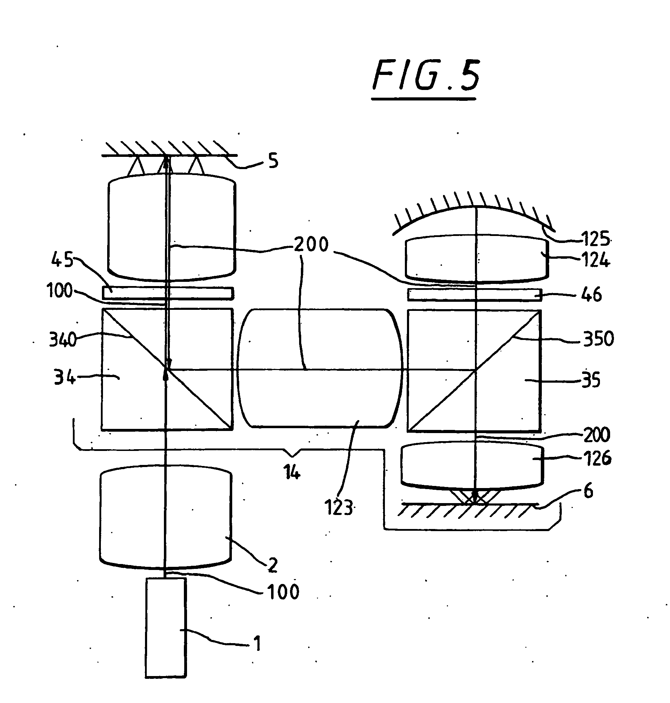

Bei der Konfiguration des Reduktionsobjektivs 12 nach Fig. 4 ist es auch denkbar, das Beleuchtungslicht 100 über den Umlenkspiegel 122 einzukoppeln, wie dies in Fig. 5 dargestellt ist.

Der Umlenkspiegel 122 in Fig. 4 kann auch durch einen Polarisations-Strahlteilerwürfel 34 ersetzt werden, wie in Fig. 5 dargestellt. Ein Polarisations-Strahlteilerwürfel 34 hat gegenüber einer Strahlteilerplatte den Vorteil, daß nur rotationssymmetrische Bildfehler eingeführt werden, die sich leichter korrigieren lassen. Im Vergleich zu einer Strahlteilerplatte dagegen hat ein Strahlteilerwürfel 34 den Nachteil, daß der zusätzliche Glasweg durch die Glasprismen zu Transmissionsverlusten führt, die gerade bei niedrigen Wellenlängen störend sind.

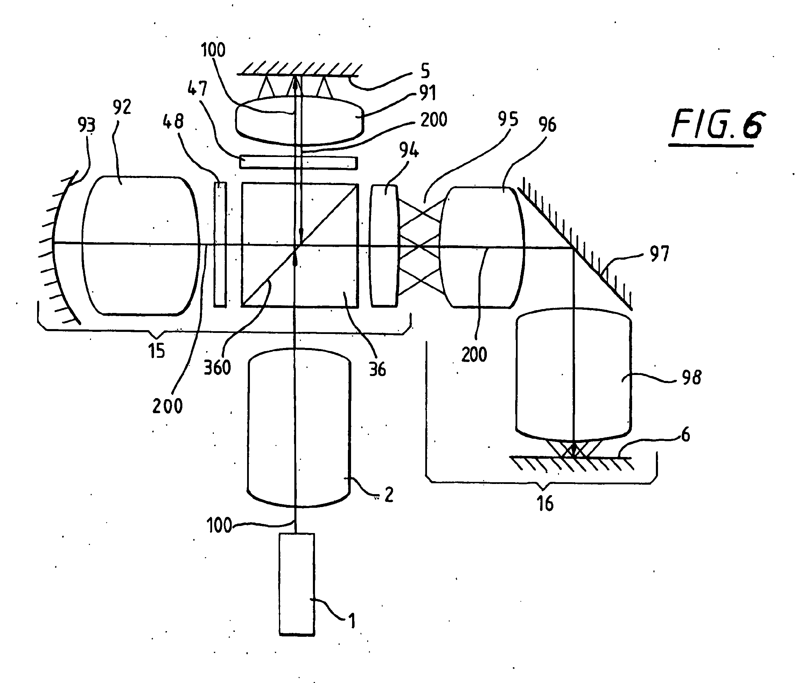

Das Beleuchtungslicht über ein Polarisations-Strahlteilerwürfel 36 einzukoppeln, bietet sich auch bei einer weiteren Klasse von Objektivdesigns an, wie sie in Fig. 6 dargestellt ist. Das Reduktionsobjektiv besteht dabei aus einem katadioptrischen Teilobjektiv 15 mit Polarisations-Strahlteilerwürfel 36, einem Zwischenbild 95 und einem refraktiven Reduktionsobjektiv 16. Das katadioptrische Teilobjektiv 15 kann dabei sowohl im Anschluß an das Retikel 5, wie in Fig. 6 zu sehen, als auch vor dem Wafer 6 angeordnet sein. Im katadioptrischen Teilobjektiv 15 ist bereits ein Polarisations-Strahlteilerwürfel 36 enthalten, über dessen vierte, noch unbenutzte Seite das Beleuchtungslicht 100 eingekoppelt werden kann.

Das aus der Beleuchtungseinrichtung 2 kommende Licht muß dabei sehr gut, vorteilhafterweise zu mehr als 95% senkrecht zur Strahlteilerfläche 360 polarisiert sein. Dadurch vermeidet man eine ungewollte Reflektion Richtung Wafer 6, wodurch Kontrast und Auflösung des Projektionsobjektives verringert werden würden.

Zwischen Polarisations-Strahlteilerwürfel 36 und Retikel 5 muß ein erstes λ/4- Plättchen 47 angebracht sein, damit die Lichtstrahlen des abbildenden Strahlengangs 200 nach Durchgang durch das λ/4 Plättchen 47 derart polarisiert sind, daß sie am Polarisations-Strahlteilerwürfel 36 Richtung Konkavspiegel 93 reflektiert werden.

Damit die Strahlteilerfläche 360 im nahezu kollimiertem Strahlengang durchsetzt wird, befinden sich zwischen Retikel 5 und Polarisations-Strahlteilerwürfel 36 optische Elemente 91, die insgesamt eine positive Brechkraft aufweisen.

Zwischen Polarisations-Strahlteilerwürfel 36 und Konkavspiegel 93 muß ein zweites λ/4-Plättchen 48 angebracht sein, damit die Lichtstrahlen des abbildenden Strahlengangs 200 nach der Reflektion am Konkavspiegel 93 den Polarisations-Strahlteilerwürfel 36 unabgelenkt in Richtung Zwischenbild 95 durchsetzen.

Zwischen dem Polarisations-Strahlteilerwürfel 36 und dem Konkavspiegel 93 befinden sich die optischen Elemente 92 mit insgesamt negativer Brechkraft. Sie werden im zweifachen Durchgang von den Lichtbündeln durchsetzt und führen eine chromatische Überkorrektion ein.

Der Konkavspiegel 93 hat den Vorteil, daß er keine chromatischen Aberrationen einführt und ausreichend positive Brechkraft aufweist, damit das katadioptrische Teilobjektiv 15 insgesamt eine positive Brechkraft aufweist.

Wird der Polarisations-Strahlteilerwürfel 3 im nahezu kollimierten Strahlengang durchsetzt, sind vor dem Zwischenbild 95 weitere optische Elemente 94 mit insgesamt positiver Brechkraft erforderlich, um das Zwischenbild zu erzeugen.

Auf die optischen Elemente 94 kann verzichtet werden, wenn das Zwischenbild 95 bereits durch die Wirkung des Konkavspiegels 93 und der optischen Elemente 92 erzeugt und auf den kollimierten Strahlengang innerhalb des Polarisations-Strahlteilerwürfels 93 verzichtet wird.

Üblicherweise wird das Objekt mit einem Abbildungsmaßstab von β₁=-1,0±0,25 auf das Zwischenbild abgebildet.

Nach dem Zwischenbild 95 folgt eine refraktive Reduktionsabbildung mit einem Abbildungsmaßstab von beispielsweise β₂=-0,25±0,15. In Fig. 6 besteht das Teilobjektiv zwischen Zwischenbild 95 und Wafer 6 aus den optischen Elementen 96, 98 und dem Umlenkspiegel 97.

Möglich ist auch, die Umlenkung 97 vor den optischen Komponenten 96 anzuordnen.

Der Durchmesser des ausgeleuchteten Feldes in der Wafer-Ebene 6 ist bei dieser Klasse von Objektiven größer als 10 mm, bei einer bildseitigen numerischen Apertur größer als 0,5.

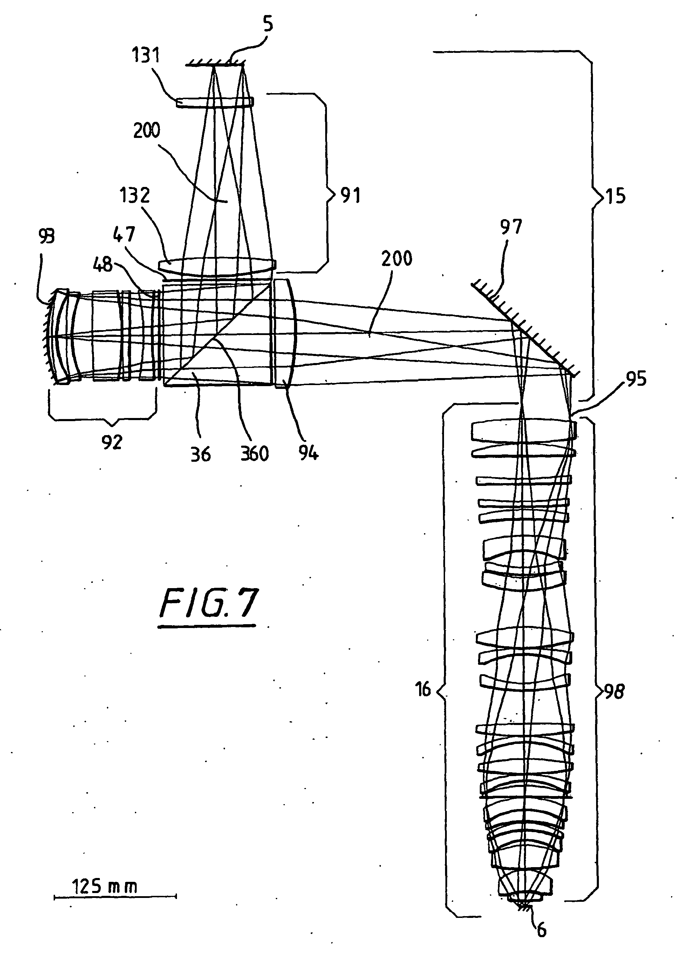

Für das in Fig.7 schematisch dargestellte Ausführungsbeispiel mit Strahlteilerwürfel und Zwischenbild zeigt Fig. 7 eine konkrete Ausführung für einen Abbildungsmaßstab β = -0,25, für ein Bildfeld mit einem Durchmesser von 14,3 mm und für eine bildseitige numerische Apertur von 0,7. Die Bezugszeichen in Fig. 7 entsprechen dabei den Bezugszeichen in Fig. 6. Die optischen Daten sind in Tabelle 1 zusammengestellt.

Das Ausführungsbeispiel der Fig. 7 ist der anhängigen Anmeldung DE 199 54 727.0 der Anmelderin entnommen und wird dort näher erläutert.

In Tabelle 1 ist der Strahlteilerfläche 360 beim ersten Kontakt die Fläche 7, dem Konkavspiegel 93 die Fläche 19, der Strahlteilerfläche 360 beim zweiten Kontakt die Fläche 31, dem Umlenkspiegel 97 die Fläche 36 und dem Zwischenbild 95 die Fläche 38 zugeordnet. SiO₂ bezeichnet Quarzglas, CaF₂ Kalziumfluorid-Einkristall.

**Tabelle 1**

| Flächennr | Radius | Dicke | Spiegel | Material |
|---|---|---|---|---|
| Retikel | ∞ | 35.000 | | |
| 1 | ∞ | 0.000 | | |
| 2 | ∞ | 10.000 | | SiO2 |
| 3 | -356.062 | 157.474 | | |
| 4 | 452.317 | 20.000 | | SiO2 |
| 5 | -207.509 | 15.494 | | |
| 6 | ∞ | 46.000 | | SiO2 |
| 7 | ∞ | -46.000 | S | SiO2 |
| 8 | ∞ | -11.450 | | |
| 9 | 714.294 | -10.000 | | Si02 |
| 10 | -233.153 | -14.054 | | |
| 11 | 11257.823 | -7.320 | | SiO2 |
| 12 | 5681.927 | -0.268 | | |
| 13 | -294.458 | -29.996 | | SiO2 |
| 14 | 2624.912 | -21.086 | | |
| 15 | 118.550 | -6.001 | | Si02 |
| 16 | 372.661 | -9.646 | | |
| 17 | 89.532 | -6.000 | | SiO2 |
| 18 | 220.679 | -3.804 | | |
| 19 | 134.415 | 3.804 | S | |
| 20 | 220.679 | 6.000 | | SiO2 |
| 21 | 89.532 | 9.646 | | |
| 22 | 372.661 | 6.001 | | SiO2 |
| 23 | 118.550 | 21.086 | | |
| 24 | 2624.912 | 29.996 | | SiO2 |
| 25 | -294.458 | 0.268 | | |
| 26 | 5681.927 | 7.320 | | SiO2 |
| 27 | 11257.823 | 14.054 | | |
| 28 | -233.153 | 10.000 | | SiO2 |
| 29 | 714.294 | 11.450 | | |
| 30 | ∞ | 46.000 | | SiO2 |
| 31 | ∞ | 46.000 | | SiO2 |
| 32 | ∞ | 0.000 | | |
| 33 | ∞ | 11.000 | | |
| 34 | -6197.721 | 20.000 | | SiO2 |
| 35 | -220.469 | 289.683 | | |
| 36 | ∞ | -35.000 | S | |
| 37 | -283.115 | -27.145 | | SiO2 |
| 38 | 291.549 | -0.100 | | |
| 39 | -169.090 | -12.856 | | SiO2 |
| 40 | -2565.582 | -24.512 | | |
| 41 | 380.926 | -6.000 | | SiO2 |
| 42 | 3955.807 | -18.476 | | |
| 43 | 360.725 | -6.000 | | SiO2 |
| 44 | 890.059 | -2.724 | | |
| 45 | -179.574 | -11.560 | | SiO2 |
| 46 | -339.907 | -16.696 | | |
| 47 | -147.863 | -16.313 | | SiO2 |
| 48 | -65.738 | -18.352 | | |
| 49 | 103.683 | -7.718 | | SiO2 |
| 50 | 197.447 | -2.785 | | |
| 51 | 111.947 | -15.000 | | SiO2 |
| 52 | 106.337 | -38.908 | | |
| 53 | -152.812 | -22.411 | | SiO2 |
| 54 | 194.070 | -0.375 | | |
| 55 | -199.667 | -7.318 | | SiO2 |
| 56 | -93.343 | -30.485 | | |
| 57 | 89.838 | -7.125 | | SiO2 |
| 58 | 197.820 | -35.859 | | |
| 59 | -713.001 | -13.228 | | Si02 |
| 60 | 274.158 | -0.375 | | |
| 61 | -106.260 | -6.375 | | SiO2 |
| 62 | -76.991 | -18.206 | | |
| 63 | -207.243 | -16.125 | | SiO2 |
| 64 | 265.977 | -0.375 | | |
| 65 | -105.982 | -6.938 | | SiO2 |
| 66 | -70.150 | -5.070 | | |
| 67 | -110.355 | -11.250 | | SiO2 |
| 68 | -337.355 | -1.500 | | |
| 69 | ∞ | 0.000 | | |
| 70 | -83.054 | -13.500 | | Si02 |
| 71 | -64.019 | -0.100 | | |
| 72 | -60.890 | -13.500 | | Si02 |
| 73 | -102.440 | -0.101 | | |
| 74 | -65.466 | -8.393 | | SiO2 |
| 75 | -75.287 | -0.523 | | |
| 76 | -74.115 | -10.249 | | SiO2 |
| 77 | -48.411 | -4.972 | | |
| 78 | -70.661 | -26.250 | | SiO2 |
| 79 | 135.365 | -0.038 | | |
| 80 | -38.281 | -23.828 | | CaF2 |
| 81 | -41.066 | 0.038 | | |
| 82 | -46.927 | -9.292 | | CaF2 |
| 83 | 187.500 | -5.625 | | |
| Wafer | ∞ | 0.000 | | |

Die optischen Elemente 91 bestehen in diesem Fall aus zwei Sammellinsen 131 und 132. Die Sammellinse 132, die nahe am Polarisations-Strahlteilerwürfel 3 angebracht ist, reduziert die Divergenz der Randstrahlen. Dadurch wird der weitgehend kollimierte Strahlengang innerhalb des Polarisations-Strahlteilerwürfels 3 hergestellt. Mit der Sammellinse 131 nahe am Retikel 5 wird ein nahezu telezentrischer Hauptstrahlverlauf am Retikel 5 erzielt. Tab. 2 gibt für 7 Objekthöhen in der Retikelebene 5 die Hauptstrahlwinkel bezüglich der Flächennormalen in mrad an. Die Hauptstrahlwinkel sind positiv, wenn die Hauptstrahlen nach der Reflektion am Retikel 5 konvergent zur optischen Achse verlaufen. Der maximale Hauptstrahlwinkel beträgt in diesem Ausführungsbeispiel nur 0,5mrad. Der Eingang am Retikel ist somit nahezu perfekt telezentrisch.

**Tabelle 2**

| Objekthöhe am Retikel [mm] | Hauptstrahlwinkel am Retikel [mrad] |
|---|---|
| 28.7 | +0.29 |
| 26.8 | +0.36 |
| 24.9 | +0.41 |
| 20.3 | +0.49 |
| 14.4 | +0.47 |
| 10.1 | +0.38 |
| 0.0 | +0.00 |

Die Anpassung der Schwerstrahlwinkel des Beleuchtungsstrahlengangs 100 im Beleuchtungssystem 2 an die Hauptstrahlwinkel des Projektionsobjektives ist in diesem Fall besonders einfach, da der Beleuchtungsstrahlengang 100 und der abbildende Strahlengang 200 innerhalb der gemeinsamen Komponenten 91 zwischen Strahlteilerwürfel 3 und Retikel 5 weitgehend überlappen.

Der Polarisations-Strahlteilerwürfel 3 und die beiden Sammellinsen 131 und 132 sind in das Design des Beleuchtungssystems 2 miteinzubeziehen. Handelt es sich bei der letzten Komponente des Beleuchtungssystem 2 vor dem Retikel um ein REMA-Objektiv, wie es in der DE 195 48 805 A1 oder DE 196 53 983 A1 beschrieben wird, so kann das REMA-Objektiv ohne große Schwierigkeiten derart abgewandelt werden, daß ein refraktiver Würfel für den Polarisations-Strahlteilerwürfel 3, eine refraktive Planplatte für das λ/4-Plättchen 47 und in der Feldlinse des ReMa-Objektives die beiden Sammellinsen 131 und 132 integriert werden.

Eine Einkopplung des Beleuchtungslichts 100 über den Umlenkspiegel 97 ist in diesem Fall nicht möglich. Die Einkopplung von Beleuchtungslicht über einen Polarisations-Strahlteilerwürfel ist nur dann möglich, wenn das Licht nach Durchgang durch diese erste Strahlteilerfläche auf keine weitere Strahlteilerfläche treffen kann, sondern nach Durchgang durch mögliche weitere optische Elemente reflektiert wird. Bei der Konfiguration nach Fig. 7 würde jedoch, wenn das Beleuchtungslicht durch den Umlenkspiegel 97 eingekoppelt werden würde, keine reflektierende Fläche, sondern eine weitere Polarisations-Strahlteilerfläche 360 des Strahlteilerwürfels 3 folgen. Eine Einkopplung wäre in diesem Fall nur über eine geometrische Strahlteilerplatte oder einen geometrischen Strahlteilerwürfel denkbar. Dies würde jedoch zu hohen Transmissionsverlusten führen.

## Patentansprüche

1. Projektionsbelichtungsanlage der Mikrolithographie mit
- einer Lichtquelle (1),
- einem Beleuchtungssystem (2) mit einem Beleuchtungsstrahlengang (100),
- einem reflektiven Retikel (5),
- einem Reduktions-Objektiv (71,72) mit einem Abbildungsstrahlengang (200),
- einem erster Strahlteilerwürfel (3), der den Beleuchtungs- (100) und Abbildungsstrahlengang (200) überlagert,
**dadurch gekennzeichnet, daß**
das Reduktionsobjektiv aus einem ersten Objektiv (7) mit integriertem erstem Strahlteilerwürfel (3) und einem zweiten Objektiv (8) besteht und daß zwischen dem ersten Objektiv (7) und dem zweiten Objektiv (8) eine Zwischenbildebene (103) liegt.

2. Projektionsbelichtungsanlage nach Anspruch 1, **dadurch gekennzeichnet, daß** zwischen dem ersten Strahlteilerwürfel (3) und dem reflektiven Retikel (5) optische Elemente (71) vorgesehen sind.

3. Projektionsbelichtungsanlage nach mindestens einem der Ansprüche 1-2, **dadurch gekennzeichnet, daß** die Inzidenzwinkel der Hauptstrahlen auf dem reflektiven Retikel (5) Werte bis zu ±15mrad, vorteilhafterweise bis zu ±5mrad, besonders bevorzugt bis zu ±1mrad aufweisen.

4. Projektionsbelichtungsanlage nach Anspruch 3, **dadurch gekennzeichnet, daß** die Winkelabweichung der Schwerstrahlen des Beleuchtungsstrahlengangs (100) nach der Reflektion am Retikel von den korrespondierenden Hauptstrahlen des Reduktions-Objektivs (71, 72) maximal ± 2,5 mrad beträgt.

5. Projektionsbelichtungsanlage nach mindestens einem der Ansprüche 1-4, **dadurch gekennzeichnet, daß** der erste Strahlteilerwürfel (3, 31, 34, 36) ein Polarisations-Strahlteilerwürfel ist und daß das Beleuchtungslicht (100) vor dem Eintritt in den Polarisations-Strahlteilerwürfel (3, 31, 34, 36) zu mehr als 95% senkrecht zur Strahlteilerfläche (310, 340, 360) linear polarisiert ist, wenn der Beleuchtungsstrahlengang (100) nicht an der Strahlteilerfläche (310, 340, 360) reflektiert werden soll, oder zu mehr als 95% parallel zur Strahlteilerfläche (30) linear polarisiert ist, wenn der Beleuchtungsstrahlengang (100) an der Strahlteilerfläche (30) reflektiert werden soll.

6. Projektionsbelichtungsanlage nach mindestens einem der Ansprüche 1-5, **dadurch gekennzeichnet, daß** das Reduktionsobjektiv ein refraktives Objektiv (71,72) ist, in dem ein erster Strahlteilerwürfel (3) vorgesehen ist.

7. Projektionsbelichtungsanlage nach mindestens einem der Ansprüche 1-6, **dadurch gekennzeichnet, daß** das erste Objektiv (7) einen Abbildungsmaßstab von -1,0 ± 0,25 und das zweite Objektiv (8) einen Abbildungsmaßstab von -0,25 ± 0,15 aufweist.

8. Projektionsbelichtungsanlage nach mindestens einem der Ansprüche 1-7, **dadurch gekennzeichnet, daß** das erste Objektiv (7) und das zweite Objektiv (8) rein refraktiv ausgebildet sind.

9. Projektionsbelichtungsanlage nach mindestens einem der Ansprüche 1-7, **dadurch gekennzeichnet, daß** das erste Objektiv (9) rein refraktiv und das zweite Objektiv (10, 11) katadioptrisch ausgebildet ist.

10. Projektionsbelichtungsanlage nach mindestens einem der Ansprüche 1-5, **dadurch gekennzeichnet, daß** das Reduktionsobjektiv ein katadioptrisches Objektiv (12, 13, 14, 15, 16) ist.

11. Projektionsbelichtungsanlage nach Anspruch 10, **dadurch gekennzeichnet, daß** das Reduktionsobjektiv (14) einen Konkavspiegel (125) und einen zweiten Strahlteilerwürfel (35) aufweist, welcher die Strahlengänge zum und vom Konkavspiegel (125) trennt.

12. Projektionsbelichtungsanlage nach Anspruch 11, **dadurch gekennzeichnet, daß** in dem Reduktionsobjektiv (12) der erste und zweite Strahlteilerwürfel (31) vereinigt sind mit einer einzigen Teilerfläche (310).

13. Projektionsbelichtungsanlage nach Anspruch 11, **dadurch gekennzeichnet, daß** in dem Reduktionsobjektiv (14) der erste Strahlteilerwürfel (34) einen Umlenkspiegel (122) ersetzt.

14. Verfahren zur Herstellung mikrostrukturierter Bauteile, bei dem ein mit einer lichtempfindlichen Schicht versehenes Substrat (6) mittels einer Maske (5) und einer Projektionsbelichtungsanlage nach mindestens einem der Ansprüche 1-13 belichtet wird und mittels einer Abbildung eines auf der Maske (5) enthaltenen Musters strukturiert wird.

## Claims

1. Projection exposure system for microlithography with
- a light source (1),
- an illumination system (2) with an illumination beam path (100),
- a reflective reticle (5),
- a reduction objective (71, 72) with an imaging beam path (200),
- a first beam splitter cube (3), which superimposes the illumination beam path (100) and imaging beam path (200),
**characterized in that**
the reduction objective comprises a first objective (7) with integrated first beam splitter cube (3) and a second objective (8) and **in that** an intermediate image plane (103) lies between the first objective (7) and the second objective (8).

2. Projection exposure system according to Claim 1, **characterized in that** optical elements (71) are provided between the first beam splitter cube (3) and the reflective reticle (5).

3. Projection exposure system according to at least one of Claims 1 - 2, **characterized in that** the angles of incidence of the principal rays on the reflective reticle (5) have values up to ± 15 mrad, advantageously up to ± 5 mrad, particularly preferably up to ± 1 mrad.

4. Projection exposure system according to Claim 3, **characterized in that** the angular deviation of the centroid rays of the illumination beam path (100) after reflection at the reticle from the corresponding principal rays of the reduction objective (71, 72) is at most ± 2.5 mrad.

5. Projection exposure system according to at least one of Claims 1 - 4, **characterized in that** the first beam splitter cube (3, 31, 34, 36) is a polarization beam splitter cube, and **in that** the illumination light (100) prior to entering into the polarization beam splitter cube (3, 31, 34, 36) is linearly polarized to more than 95% perpendicular to the beam splitter surface (310, 340, 360) if the illumination beam path (100) is not intended to be reflected at the beam splitter surface (310, 340, 360) or is linearly polarized to more than 95% parallel to the beam splitter surface (30) if the illumination beam path (100) is intended to be reflected at the beam splitter surface (30).

6. Projection exposure system according to at least one of Claims 1 - 5, **characterized in that** the reduction objective is a refractive objective (71, 72) in which a first beam splitter cube (3) is provided.

7. Projection exposure system according to at least one of Claims 1 - 6, **characterized in that** the first objective (7) has an imaging scale of -1.0 ± 0.25 and the second objective (8) has an imaging scale of -0.25 ± 0.15.

8. Projection exposure system according to at least one of Claims 1 - 7, **characterized in that** the first objective (7) and the second objective (8) are formed in purely refractive fashion.

9. Projection exposure system according to at least one of Claims 1 - 7, **characterized in that** the first objective (9) is formed in purely refractive fashion and the second objective (10, 11) is formed in catadioptric fashion.

10. Projection exposure system according to at least one of Claims 1 - 5, **characterized in that** the reduction objective is a catadioptric objective (12, 13, 14, 15, 16).

11. Projection exposure system according to Claim 10, **characterized in that** the reduction objective (14) has a concave mirror (125) and a second beam splitter cube (35), which separates the beam paths to and from the concave mirror (125).

12. Projection exposure system according to Claim 11, **characterized in that** in the reduction objective (12) the first and second beam splitter cubes (31) are combined with a single splitter surface (310).

13. Projection exposure system according to Claim 11, **characterized in that** in the reduction objective (14) the first beam splitter cube (34) replaces a deflection mirror (122).

14. Method for producing microstructured components, in which a substrate (6) provided with a light-sensitive layer is exposed by means of a mask (5) and a projection exposure system according to at least one of Claims 1 - 13 and is patterned by means of an imaging of a pattern contained on the mask (5).

## Revendications

1. Système d'exposition par projection de microlithographie avec:
une source lumineuse (1),
un système d'illumination (2) avec un chemin optique d'illumination (100),
un réticule réflectif (5)
un objectif réducteur (71, 72) avec un chemin optique de reproduction (200),
un premier cube séparateur de faisceau (3) qui interfère avec le chemin optique d'illumination (100) et le chemin optique de reproduction (200),
**caractérisé en ce que** l'objectif réducteur est constitué d'un premier objectif (7) avec un premier cube séparateur de faisceau intégré (3) et d'un deuxième objectif (8), et **en ce qu'**un plan d'image intermédiaire (103) se trouve entre, le premier objectif (7) et le deuxième objectif (8).

2. Système d'exposition par projection selon la revendication 1, **caractérisé en ce qu'**on prévoit des éléments optiques (71) entre le premier cube séparateur de faisceau intégré (3) et le réticule réflectif (5).

3. Système d'exposition par projection selon une au moins des revendications 1 - 2, **caractérisé en ce que** les angles d'incidence des faisceaux principaux sur le réticule réflectif (5) présentent des valeurs jusqu'à ±15 mrad, avantageusement jusqu'à ±5 mrad, et de préférence jusqu'à ±1 mrad.

4. Système d'exposition par projection selon la revendication 3, **caractérisé en ce qu'**après réflexion sur le réticule, la déviation angulaire des faisceaux lourds du chemin optique d'illumination (100) s'élève au maximum à ±2,5 mrad par rapport aux faisceaux principaux correspondants de l'objectif réducteur (71, 72).

5. Système d'exposition par projection selon une au moins des revendications 1 - 4, **caractérisé en ce que** le premier cube séparateur de faisceau (3, 31, 34, 36) est un cube séparateur de faisceau polarisant et **en ce qu'**avant de pénétrer dans le cube séparateur de faisceau polarisant (3, 31, 34, 36), la lumière d'illumination (100) est polarisée linéairement à plus de 95% perpendiculairement à la surface de séparation de faisceau (310, 340, 360) lorsque le chemin optique d'illumination (100) ne doit pas être réfléchi sur la surface de séparation de faisceau (310, 340, 360), ou qu'elle est polarisée linéairement à plus de 95% parallèlement à la surface de séparation de faisceau (30) lorsque le chemin optique d'illumination (100) doit se réfléchir sur la surface de séparation de faisceau (30).

6. Système d'exposition par projection selon une au moins des revendications 1 - 5, **caractérisé en ce que** l'objectif réducteur est un objectif réfractif (71, 72) dans lequel est prévu un premier cube séparateur de faisceau (3).

7. Système d'exposition par projection selon une au moins des revendications 1 - 6, **caractérisé en ce que** le premier objectif (7) présente une échelle de reproduction de -1,0 ±0,25 et le deuxième objectif (8) une échelle de reproduction de -0,25 ±0,15.

8. Système d'exposition par projection selon une au moins des revendications 1 - 7, **caractérisé en ce que** le premier objectif (7) et le deuxième objectif (8) sont développés sous forme purement réfractive.

9. Système d'exposition par projection selon une au moins des revendications 1 - 7, **caractérisé en ce que** le premier objectif (9) est développé sous forme purement réfractive et le deuxième objectif (10, 11) sous forme catadioptrique.

10. Système d'exposition par projection selon une au moins des revendications 1 - 5, **caractérisé en ce que** l'objectif réducteur est un objectif catadioptrique (12, 13, 14, 15, 16).

11. Système d'exposition par projection selon la revendication 10, **caractérisé en ce que** l'objectif réducteur (14) présente un miroir concave (125) et un deuxième cube séparateur de faisceau (35) qui sépare les chemins optiques en direction et à partir du miroir concave (125).

12. Système d'exposition par projection selon la revendication 11, **caractérisé en ce que** dans l'objectif réducteur (12), le premier et le deuxième cube séparateur de faisceau (31) sont réunis avec une seule surface de séparation (310).

13. Système d'exposition par projection selon la revendication 11, **caractérisé en ce que** dans l'objectif réducteur (14), le premier cube séparateur de faisceau (34) remplace un miroir déflecteur (122).

14. Procédé de fabrication de composants microstructurés dans lequel un substrat (6) doté d'une couche photosensible est exposé au moyen d'un masque (5) et d'un système d'exposition par projection selon une au moins des revendications 1 - 13, et est structuré au moyen d'une reproduction d'un motif contenu dans le masque (5).
